# EUROPEAN PATENT APPLICATION

(11) **EP 4 435 846 A1**
(43) Date of publication of application: **25.09.2024**
(21) Application number: 23216030.9
(22) Date of filing: 12.12.2023
(51) Int. Cl.: H01L 21/8234, H01L 27/088, H01L 29/06, H01L 29/66, H01L 29/775, H01L 21/768, H01L 23/48

(54) **SEMICONDUCTOR DEVICES BETWEEN GATE CUTS AND DEEP BACKSIDE VIAS**

(30) Priority: 23.03.2023 US 202318125430
(71) Applicant: INTEL Corporation, Santa Clara, CA 95054 (US)
(72) Inventor: GULER, Leonard P., Hillsboro, 97124 (US); LIU, Shengsi, Portland, 97229 (US); ACHARYA, Saurabh, Beaverton, 97007 (US); ZHU, Baofu, 97229 Portland (DE); WALLACE, Charles H., Portland, 97212 (US)
(74) Representative: 2SPL Patentanwälte PartG mbB

(57) **Abstract**

Techniques are provided herein to form semiconductor devices arranged between a gate cut on one side and a deep backside via on the other side. A row of semiconductor devices each include a semiconductor region (102, 104) extending in a first direction between corresponding source or drain regions, and a gate structure (106) extending in a second direction over the semiconductor regions. Each semiconductor device is separated from an adjacent semiconductor device along the second direction by either a gate cut (112) or a deep backside via (114). The gate cut is a dielectric wall that extends through an entire thickness of the gate structure and the deep backside via includes a conductive layer and may further include a dielectric barrier that also extend through at least an entire thickness of the gate structure. Each semiconductor device has a gate cut on one side and a deep backside via on the other side.

## Description

### FIELD OF THE DISCLOSURE

The present disclosure relates to integrated circuits, and more particularly, to gate cuts and deep conductive vias.

### BACKGROUND

As integrated circuits continue to scale downward in size, a number of challenges arise. For instance, reducing the size of memory and logic cells is becoming increasingly more difficult, particularly given competing interests in a relatively small amount of space. For instance, routing signal and power throughout the circuit can be challenging given the limited space and density of the devices. Furthermore, electrical isolation between adjacent devices is important to reduce parasitic effects and leakages. Accordingly, there remain a number of non-trivial challenges with respect to the formation of semiconductor devices in memory or logic cells.

### BRIEF DESCRIPTION OF THE DRAWINGS

Figure 1A is an isometric view of an integrated circuit structure that includes both a gate cut and deep backside vias, in accordance with an embodiment of the present disclosure.
Figure 1B is a cross-section view through the gate trench of the integrated circuit of Figure 1A showing devices separated by a gate cut and deep backside vias, in accordance with an embodiment of the present disclosure.
Figure 1C is a plan view of the integrated circuit of Figure 1A showing both gate cuts and deep backside vias extending between devices, in accordance with an embodiment of the present disclosure.
Figures 2A - 2J are cross-sectional views that illustrate stages in an example process for forming an integrated circuit configured with both gate cut(s) and deep backside via(s), in accordance with some embodiments of the present disclosure.
Figure 3 illustrates a cross-section view of a chip package containing one or more semiconductor dies, in accordance with some embodiments of the present disclosure.
Figure 4 is a flowchart of a fabrication process for a semiconductor device having both gate cut(s) and deep backside via(s), in accordance with an embodiment of the present disclosure.
Figure 5 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices arranged between a gate cut on one side and a deep backside via on the other side. The techniques can be used in any number of integrated circuit applications and are particularly useful with respect to logic and memory cells, such as those cells that use finFETs or gate-all-around transistors (e.g., ribbonFETs and nanowire FETs). In an example, a row of semiconductor devices each include a semiconductor region extending in a first direction between corresponding diffusion regions (e.g., source or drain regions), and a gate structure extending in a second direction over the semiconductor regions of each neighboring semiconductor device along the row. Each semiconductor device may be separated from an adjacent semiconductor device along the second direction by either a gate cut or a deep backside via. The gate cut may be a dielectric wall that extends through an entire thickness of the gate structure and runs in the first direction between any number of devices. The deep backside via may include a conductive layer and a dielectric barrier that also extend through at least an entire thickness of the gate structure and run in the first direction between any number of devices. Each semiconductor device in an array of such devices may include a gate cut on one side and a deep backside via on the other side, such that the gate cuts and deep backside vias run in the first direction and alternate with one another along the second direction. Numerous variations and embodiments will be apparent in light of this disclosure.

### General Overview

As previously noted above, there remain a number of non-trivial challenges with respect to formation of various semiconductor structures. Power and signal routing can be challenging given the number and density of semiconductor devices on a single die. Power routing may be performed by running large conductive traces on the backside of the die (e.g., after removing the semiconductor substrate). Often in such cases, deep backside vias are used to connect any topside interconnects with the power traces on the backside of the die. The fabrication of such deep vias is non-trivial and can involve numerous additional masking steps.

Thus, and in accordance with an embodiment of the present disclosure, techniques are provided herein to form both gate cuts and deep backside vias along semiconductor devices. The techniques may allow for a more efficient process, relative to existing techniques. In an example, each semiconductor device includes a semiconductor region, such as a fin of semiconductor material or nanoribbons, nanowires, or nanosheets of semiconductor material, that extends between source or drain regions in a first direction. A gate structure, that includes both a gate dielectric and a gate electrode, extends over the semiconductor region in a second direction different from the first direction (e.g., orthogonal to the first direction). The gate structure may extend over multiple semiconductor regions of different semiconductor devices along the second direction. According to some embodiments, the gate structure is interrupted by any number of gate cuts that extend through an entire thickness of the gate structure and also extend in the first direction through any number of gate trenches and source/drain trenches. The gate structure is also interrupted by any number of deep backside vias that similarly extend through an entire thickness of the gate structure and also extend in the first direction through any number of gate trenches and source/drain trenches.

The gate cuts may be dielectric walls that include any suitable dielectric material, such as silicon nitride or any number of other dielectric materials (e.g., such as low-k dielectric materials with a dielectric constant equal to or lower than that of silicon dioxide, such as porous silicon dioxide, or equal to or lower than 3.9). The deep backside vias may include a conductive layer between dielectric walls to separate the conductive layer of the via from the gate electrode of the gate structure. The conductive layer may include any suitable conductive material such as tungsten, cobalt, or molybdenum, to name a few examples. The dielectric walls may be any suitable dielectric material such as any low-k dielectric material. According to some embodiments, the gate cuts alternate with the deep backside vias along the second direction such that each semiconductor device in a grid of such devices is between a gate cut on one side and a deep backside via on the opposite side along the second direction.

According to an embodiment, an integrated circuit includes a semiconductor device having a semiconductor region extending in a first direction from a first source or drain region to a second source or drain region, and a gate electrode extending in a second direction over the semiconductor region, a dielectric wall extending in the first direction through an entire thickness of the gate electrode and extending in the first direction adjacent to the first source or drain region and the second source or drain region, and a conductive via extending in the first direction through an entire thickness of the gate electrode and extending in the first direction adjacent to the first source or drain region and the second source or drain region. The semiconductor device is between the dielectric wall and the conductive via along the second direction.

According to another embodiment, an integrated circuit includes a first semiconductor device having a first semiconductor region extending in a first direction from a first source or drain region to a second source or drain region, and a first gate structure extending in a second direction over the first semiconductor region, and a second semiconductor device having a second semiconductor region extending in the first direction from a third source or drain region to a fourth source or drain region, and a second gate structure extending in the second direction over the second semiconductor region. The third source or drain region is aligned with the first source or drain region along the second direction, and the fourth source or drain region is aligned with the second source or drain region along the second direction. The integrated circuit further includes a dielectric wall extending in the first direction between and contacting the first gate structure and the second gate structure, extending in the first direction between the first and third source or drain regions, and extending in the first direction between the second and fourth source or drain regions. The integrated circuit further includes a first conductive via extending in the first direction through an entire thickness of the first gate structure and extending in the first direction adjacent to the first source or drain region and the second source or drain region, such that the first semiconductor device is between the dielectric wall and the first conductive via along the second direction, and a second conductive via extending in the first direction through an entire thickness of the second gate structure and extending in the first direction adjacent to the third source or drain region and the fourth source or drain region, such that the second semiconductor device is between the dielectric wall and the second conductive via along the second direction.

According to another embodiment, a method of forming an integrated circuit includes forming a fin comprising semiconductor material, the fin extending above a substrate and extending in a first direction; forming a dielectric layer adjacent to a bottom portion of the fin; forming source or drain regions at opposite ends of the fin; forming a sacrificial material over the source or drain regions; forming a gate structure on the dielectric layer and over the semiconductor material and extending in a second direction; forming a dielectric wall through an entire thickness of the gate structure and through an entire thickness of the sacrificial material, the dielectric wall extending in the first direction adjacent to a first side of the fin; and forming a conductive via through an entire thickness of the gate structure and through an entire thickness of the sacrificial material, the conductive via extending in the first direction adjacent to a second side of the fin opposite from the first side of the fin.

The techniques can be used with any type of non-planar transistors, including finFETs (sometimes called double-gate transistors, or tri-gate transistors), or nanowire and nanoribbon transistors (sometimes called gate-all-around transistors), to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of both gate cuts (extending between multiple devices) and deep backside vias (extending between multiple devices) running parallel to one another. The deep backside vias may alternate with gate cuts such that each semiconductor device has a gate cut adjacent to one side and a deep backside via adjacent to an opposite side. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

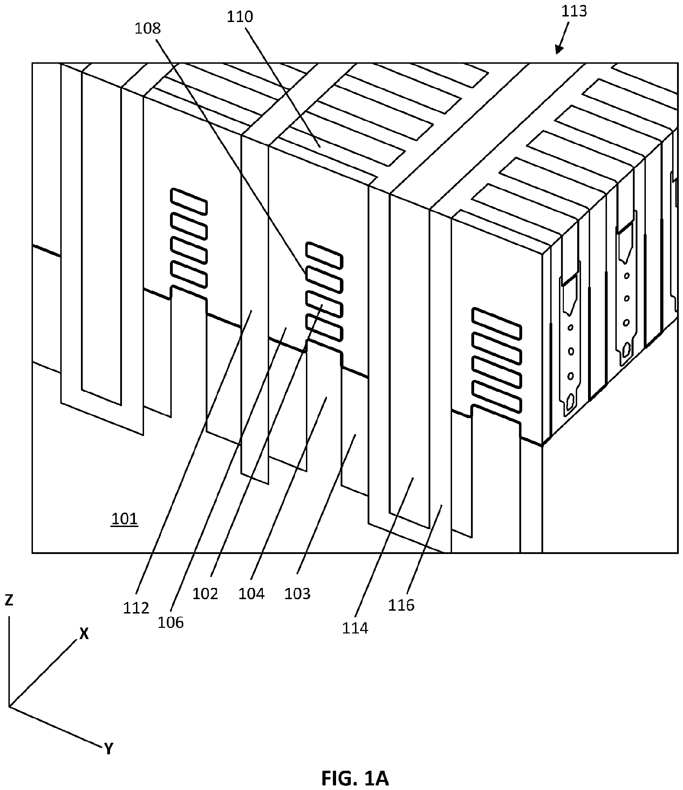

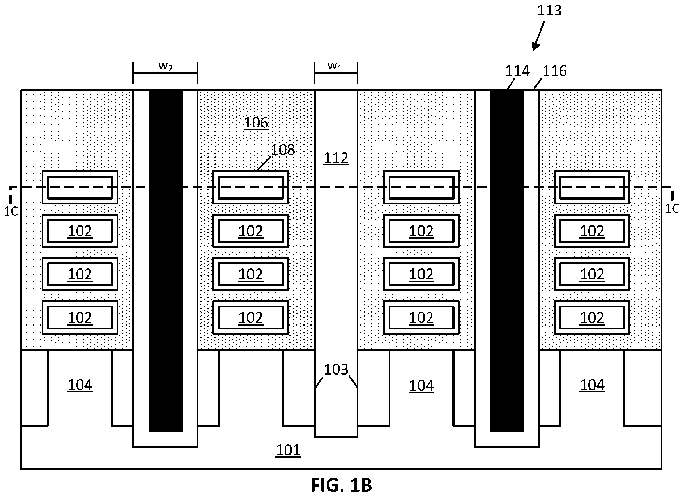

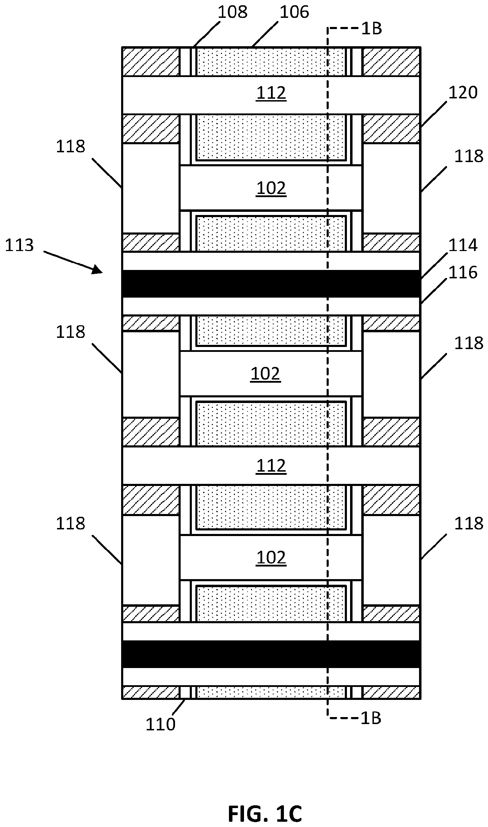

Figure 1 is an isometric view of a portion of an integrated circuit that includes semiconductor devices arranged in a grid-like pattern, in accordance with an embodiment of the present disclosure. Each of the semiconductor devices may be non-planar metal oxide semiconductor (MOS) transistors, such as tri-gate or gate-all-around (GAA) transistors, although other transistor topologies and types could also benefit from the techniques provided herein. The examples herein illustrate semiconductor devices with a GAA structure (e.g., having nanoribbons, nanowires, or nanosheets that extend between source and drain regions).

The one or more semiconductor regions of the devices may include fins that can be, for example, native to the substrate (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around process can then be carried out. Again, the alternating layers can be blanket deposited and then etched into fins or deposited into fin-shaped trenches.

The semiconductor material used in each of the semiconductor devices may be formed from a semiconductor substrate 101. Substrate 101 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, the substrate can be a semiconductor-on-insulator substrate having a desired semiconductor layer over a buried insulator layer (e.g., silicon over silicon dioxide). Alternatively, the substrate can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, substrate 101 is removed and replaced with one or more backside interconnect layers to form backside signal and power routing.

Each semiconductor device includes one or more semiconductor regions, such as one or more nanoribbons 102 extending between epitaxial source or drain regions (not shown in this view) in a first direction along the X-axis. As can further be seen, a dielectric layer 103 extends across a bottom portion of the integrated circuit and adjacent to subfins 104 of each of the semiconductor devices, according to an embodiment. Dielectric layer 103 may include any suitable dielectric material such as silicon oxide. Dielectric layer 103 may provide shallow trench isolation (STI) between adjacent semiconductor devices. According to some embodiments, subfin 104 is a portion of the corresponding semiconductor fin that remains after formation of the various transistors and may be formed from semiconductor substrate 101. Accordingly, subfin 104 may include the same semiconductor material as the one or more semiconductor regions of the semiconductor devices.

A gate structure that includes gate electrode 106 and a gate dielectric 108 extends over the one or more semiconductor regions in a second direction (e.g. along the Y-axis) to form the transistor gate. Gate dielectric 108 may represent any number of dielectric layers. Gate electrode 106 may include any sufficiently conductive material such as a metal, metal alloy, or doped polysilicon. In some embodiments, gate electrode 106 includes one or more workfunction metals around the one or more semiconductor regions. In some embodiments, p-channel devices include a workfunction metal having titanium around its one or more semiconductor regions and n-channel devices include a workfunction metal having tungsten around its one or more semiconductor regions. Gate electrode 106 may also include a fill metal or other conductive material around the workfunction metals to provide the whole gate electrode structure. A given gate structure may extend over the semiconductor regions of more than one semiconductor device.

According to some embodiments, spacer structures 110 are present on the sidewalls of the gate structure and define a gate trench in which the gate structure is formed. Spacer structures 110 may include a suitable dielectric material such as silicon nitride or
silicon oxynitride. Spacer structures 110 may run against the sidewalls of the gate structure in the second direction along the Y-axis.

According to some embodiments, one or more dielectric walls 112 (e.g., gate cuts) extend across the gate structure in the first direction (e.g., parallel to the length of nanoribbons 102). Dielectric walls 112 may continue to extend in the first direction across any number of other gate trenches and source/drain trenches. According to some embodiments, one or more dielectric walls 112 include any suitable dielectric material, such as silicon nitride, silicon oxide, or silicon oxynitride. According to some embodiments, one or more dielectric walls 112 extend at least through an entire thickness of the gate structures within the gate trenches. In some examples, one or more dielectric walls 112 also extend through an entire thickness of dielectric layer 103 (as illustrated). One or more dielectric walls 112 may include the same dielectric material as spacer structures 110.

According to some embodiments, one or more backside vias 113 also extend across the gate structure in the first direction (e.g., parallel to the length of nanoribbons 102). Similar to one or more dielectric walls 112, one or more backside vias 113 extend at least through an entire thickness of the gate structures within the gate trenches and may also extend through an entire thickness of dielectric layer 103 (as illustrated). According to some embodiments, one or more backside vias 113 include a conductive via 114 and a liner 116 to isolate conductive via 114 from gate electrode 106. Conductive via 114 may include any suitable conductive material such as tungsten, molybdenum, ruthenium, titanium, tantalum, cobalt, or any alloys thereof. Liner 116 may be any suitable dielectric material. In some examples, liner 116 includes a low-k dielectric material such as silicon nitride, tin nitride, or tin oxide, to name a few examples.

According to some embodiments, each semiconductor device includes a gate structure that is adjacent to both a dielectric wall 112 and a backside via 113. Thus, dielectric walls 112 and backside vias 113 may alternate with one another along the second direction, such that each device along the second direction is between a dielectric wall 112 and a backside via 113. Dielectric walls 112 and backside vias 113 may be formed at different times, such that the distance in the second direction between dielectric walls 112 and adjacent devices may be different than the distance in the second direction between backside vias 113 and adjacent devices.

Figure 1B illustrates a cross-section view of the integrated circuit through the gate trench. The uppermost width wi of dielectric walls 112 may be less than the uppermost width w₂ of backside vias 113. In some examples, dielectric walls 112 have an uppermost width wi between about 10 nm and about 20 nm and backside vias 113 have an uppermost width w₂ between about 20 nm and about 30 nm.

Figure 1C illustrates a plan view of the integrated circuit taken through the 1C plane illustrated in Figure 1B. The cross-section view in Figure 1B is taken across the 1B plane illustrated in Figure 1C. Nanoribbons 102 from different devices extend between corresponding source or drain regions 118 in the first direction. Source or drain regions 118 may be formed at the ends of the one or more semiconductor regions (such as at the ends of nanoribbons 102) of each device, and thus may be aligned along the second direction from one another within a common source/drain trench. According to some embodiments, source or drain regions 118 are epitaxial regions that are provided on the semiconductor regions in an etch-and-replace process. In other embodiments source or drain regions 118 could be, for example, implantation-doped native portions of the fins or substrate. Any semiconductor materials suitable for source or drain regions can be used (e.g., group IV and group III-V semiconductor materials). Source or drain regions 118 may include multiple layers such as liners and capping layers to improve contact resistance. In any such cases, the composition and doping of source or drain regions 118 may be the same or different, depending on the polarity of the transistors. Any number of source or drain configurations and materials can be used. According to some embodiments, a dielectric fill 120 is provided adjacent to source or drain regions 118 within the source/drain trench. Dielectric fill 120 may be any suitable dielectric material, such as silicon dioxide, and may also extend over a top surface of any of source or drain regions 118. Figure 1C further shows the parallel pattern of dielectric walls 112 and backside vias 113, all running in the first direction, and alternating in the second direction.

### Fabrication Methodology

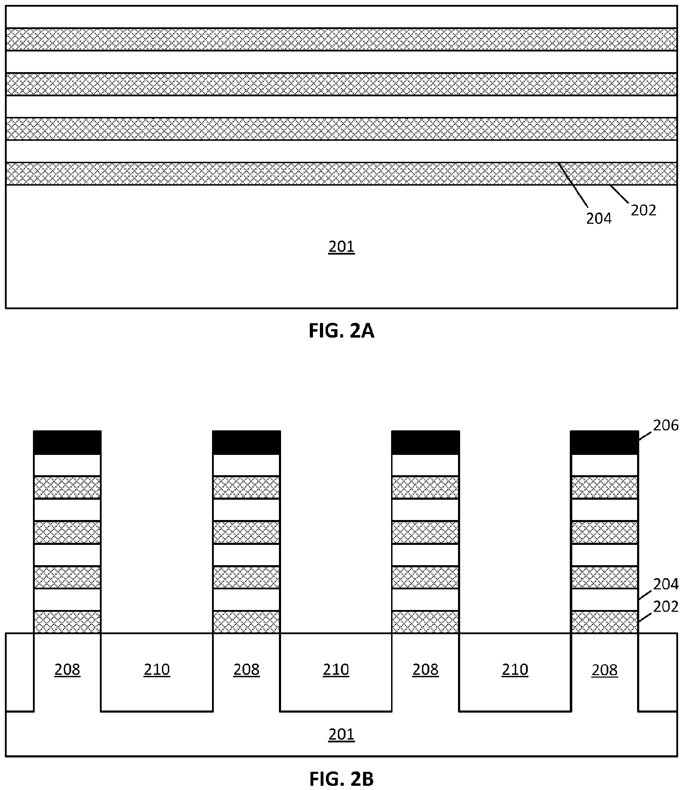

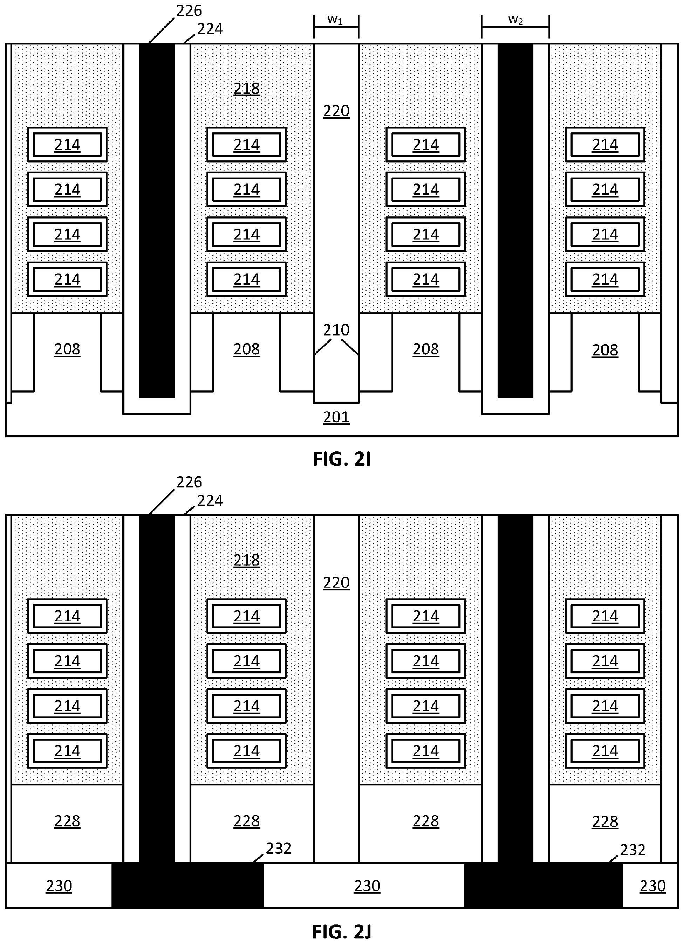

Figures 2A - 2J are cross-sectional views that collectively illustrate an example process for forming an integrated circuit configured with both gate cut(s) and deep backside via(s), in accordance with an embodiment of the present disclosure. The figures represent cross-sectional views taken along the YZ plane in the gate trench of Figure 1A. Each figure shows an example structure that results from the process flow up to that point in time, so the depicted structure evolves as the process flow continues, culminating in the structure shown in Figure 2I, which is similar to the structure shown in Figure 1B, or in Figure 2J. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated.

Figure 2A illustrates a cross-sectional view of multiple material layers formed over a substrate, according to an embodiment of the present disclosure. Alternating material layers may be deposited over a substrate 201 including sacrificial layers 202 alternating with semiconductor layers 204. The alternating layers are used to form GAA transistor structures. Any number of alternating semiconductor layers 204 and sacrificial layers 202 may be deposited over substrate 201.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202 and semiconductor layers 204 may be deposited using any known material deposition technique, such as chemical vapor deposition (CVD), plasma-enhanced chemical vapor deposition (PECVD), physical vapor deposition (PVD), or atomic layer deposition (ALD).

Figure 2B depicts the cross-section view of the structure shown in Figure 2A, following the formation of a cap layer 206 and the subsequent formation of fins beneath cap layer 206, according to an embodiment. Cap layer 206 may be any suitable hard mask material such as a carbon hard mask (CHM) or silicon nitride. Cap layer 206 is patterned into rows to form corresponding rows of fins from the alternating layer stack of sacrificial layers 202 and semiconductor layers 204. The rows of fins extend lengthwise in a first direction (e.g., into and out of the page of each cross-section view).

According to some embodiments, an anisotropic etching process through the layer stack continues into at least a portion of substrate 201, where the unetched portions of substrate 201 beneath the fins form subfin regions 208. The etched portions of substrate 201 may be filled with a dielectric fill 210 that acts as shallow trench isolation (STI) between adjacent fins. Dielectric fill 210 may be any suitable dielectric material such as silicon dioxide, and may be recessed to a desired depth as shown (in this example case, down to around the upper surface of subfin regions 208), so as to define the active portion of the fins that will be covered by a gate structure. In some embodiments, dielectric fill 210 is recessed below the top surface of subfin regions 208.

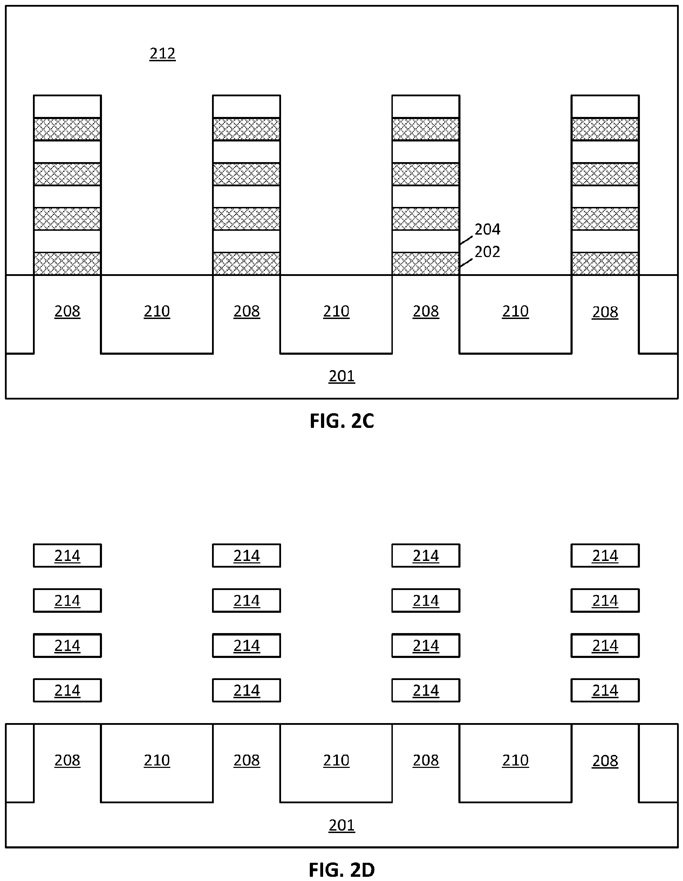

Figure 2C depicts the cross-section view of the structure shown in Figure 2B, following the formation of a sacrificial gate 212 extending across the fins in a second direction different from the first direction, according to some embodiments. Sacrificial gate 212 may extend across the fins in a second direction that is orthogonal to the first direction. According to some embodiments, the sacrificial gate material is formed in parallel strips across the integrated circuit and removed in all areas not protected by a gate masking layer. Sacrificial gate 212 may be any suitable material that can be selectively removed without damaging the semiconductor material of the fins. In some examples, sacrificial gate 212 includes polysilicon.

Sacrificial gate 212 (along with any gate spacers formed on the sidewalls of sacrificial gate 212) protect the underlying portions of the fins while the exposed portions of the fins between the gate spacers are etched away. According to some embodiments, both semiconductor layers 204 and sacrificial layers 202 are etched at substantially the same rate using an anisotropic RIE process to form source/drain trenches. In some embodiments, inner gate spacers can be formed after the source/drain trenches are etched and before any formation of source or drain regions. For instance, a selective etch can be used to laterally recess sacrificial layers 202, and that recess can then be filled with inner gate spacer material (e.g., silicon nitride or silicon oxynitride). Any excess gate spacer material can be removed with directional etching.

According to some embodiments, source or drain regions are formed after the formation of sacrificial gate 212. The source or drain regions are not shown in this cross-section as they would exist at the ends of the semiconductor layers 204 into and out of the page. The source or drain regions may be epitaxially grown from the exposed ends of semiconductor layers 204, such that the material grows together or otherwise merges towards the middle of the trenches between fins, according to some embodiments. Note that epitaxial growth on one semiconductor layer 204 can fully or partially merge with epitaxial growth on one or more other semiconductor layers 204 in the same vertical stack. The degree of any such merging can vary from one embodiment to the next. In the example of a PMOS device, a given source or drain region may be a semiconductor material (e.g., group IV or group III-V semiconductor materials) having a higher dopant concentration of p-type dopants compared to n-type dopants. In the example of an NMOS device, a given source or drain region may be a semiconductor material (e.g., group IV or group III-V semiconductor materials) having a higher dopant concentration of n-type dopants compared to p-type dopants. According to some embodiments, the source or drain regions grown from different semiconductor devices may be aligned along the source/drain trench in the second direction.

Figure 2D depicts the cross-section view of the structure shown in Figure 2C following the formation of nanoribbons 214 from semiconductor layers 204, according to some embodiments. Depending on the dimensions of the structures, nanoribbons 214 may also be considered nanowires or nanosheets. Sacrificial gate 212 may be removed using any wet or dry isotropic process thus exposing the alternating layer stack of the fins within the trenches left behind after the removal of sacrificial gate 212. Once sacrificial gate 212 is removed, sacrificial layers 202 may also be removed using a selective isotropic etching process that removes the material of sacrificial layers 202 but does not remove (or removes very little of) semiconductor layers 204 or any other exposed layers (e.g., inner gate spacers). At this point, the suspended (sometimes called released) semiconductor layers 204 form nanoribbons 214 that extend in the first direction (into and out of the page) between corresponding source or drain regions.

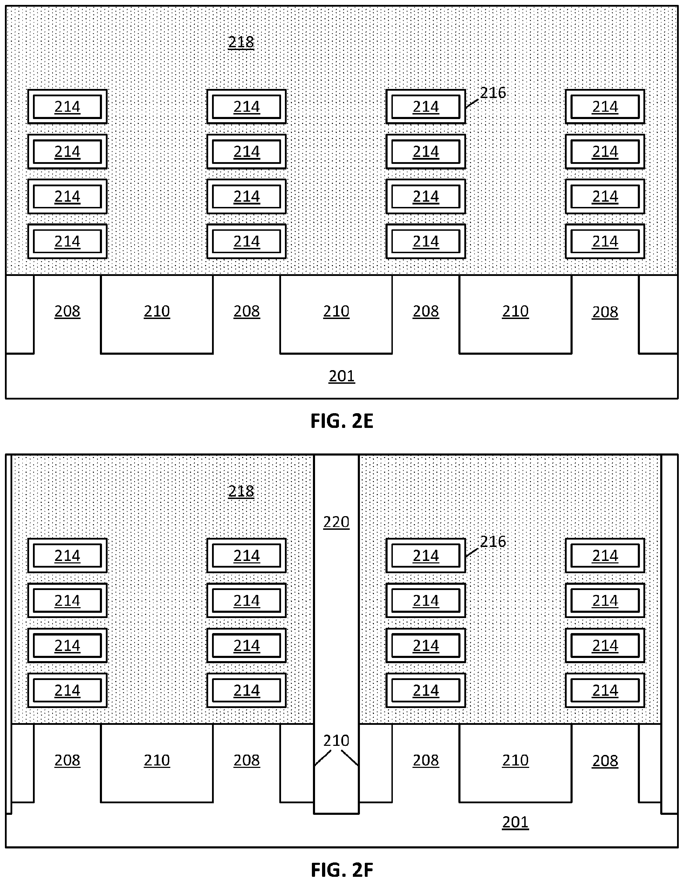

Figure 2E depicts the cross-section view of the structure shown in Figure 2D following the formation of a gate structure around nanoribbons 214 within the gate trench, according to some embodiments. As noted above, the gate structure includes a gate dielectric 216 and a gate electrode 218. Gate dielectric 216 may be conformally deposited around nanoribbons 214 using any suitable deposition process, such as atomic layer deposition (ALD). Gate dielectric 216 may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 216 is hafnium oxide with a thickness between about 1 nm and about 5 nm. In some embodiments, gate dielectric 216 may include one or more silicates (e.g., titanium silicate, tungsten silicate, niobium silicate, and silicates of other transition metals). Gate dielectric 216 may be a multilayer structure, in some examples. For instance, gate dielectric 216 may include a first layer on nanoribbons 214, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on gate dielectric 216 to improve its quality when a high-k dielectric material is used. In some embodiments, the high-k material can be nitridized to improve its aging resistance.

Gate electrode 218 may be deposited over gate dielectric 216 and can be any conductive structure. In some embodiments, gate electrode 218 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 218 may include, for instance, one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

Figure 2F depicts the cross-section view of the structure shown in Figure 2E following the formation of dielectric walls 220 extending in the first direction between adjacent devices, according to some embodiments. Dielectric walls 220 extend to a depth at least through an entire thickness of the gate structures to isolate separate gate structures along the second direction. In some embodiments, dielectric walls 220 extend into at least a portion of dielectric fill 210 or through an entire thickness of dielectric fill 210. In some embodiments, dielectric walls 220 extend entirely through dielectric fill 210 and into a portion of substrate 201.

According to some embodiments, dielectric walls 220 may be formed by first forming corresponding gate cut recesses through at least an entire thickness of gate electrode 218 using any suitable metal gate etch process that iteratively etches through portions of gate electrode 218 while simultaneously protecting the sidewalls of the recess from lateral etching to provide a high height-to-width aspect ratio recess (e.g., aspect ratio of 5:1 or higher, or 10:1 or higher). The gate cut recesses may extend in the first direction through multiple gate trenches and source/drain trenches to isolate adjacent gate structures and source or drain regions. The gate cut recesses may be filled with one or more dielectric materials to form dielectric walls 220. For example, dielectric walls 220 may include only silicon oxide or silicon nitride or silicon carbide. In some examples, dielectric walls 220 include a first dielectric layer deposited first and a second dielectric layer or dielectric fill formed on the first dielectric layer. The first dielectric layer may include a high-k dielectric material (e.g., materials with a dielectric constant higher than that of silicon oxide or higher than 3.9) while the second dielectric layer may include a low-k dielectric material (e.g. materials with a dielectric constant equal to or lower than that of silicon oxide, such as porous silicon oxide, or equal to or lower than 3.9).

According to some embodiments, dielectric walls 220 are not formed between every adjacent pair of devices along the second direction. As shown in Figure 2F, dielectric walls 220 may be formed between every other pair of adjacent devices along the gate trench.

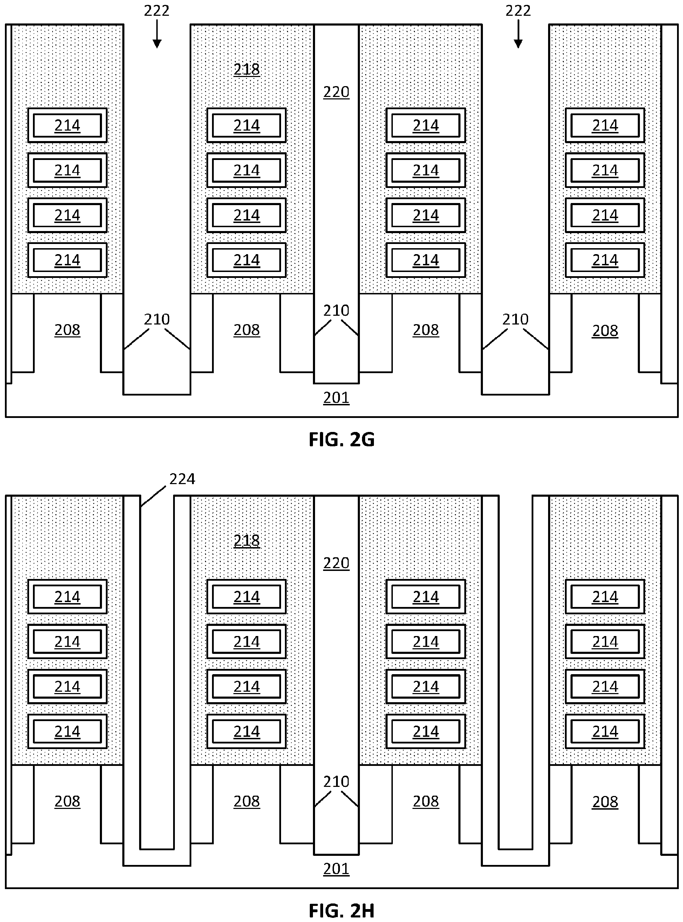

Figure 2G depicts the cross-section view of the structure shown in Figure 2F following the formation of via recesses 222, according to some embodiments. Similar to the formation of the recesses to form dielectric walls 220, any suitable metal gate etch process may be used to iteratively etch through portions of gate electrode 218 while simultaneously protecting the sidewalls of the recess from extensive lateral etching. A reactive ion etching process continues through at least a portion of the thickness of dielectric fill 210 or through an entire thickness of dielectric fill 210.

Via recesses 222 may be generally wider along the second direction compared to the recesses used to form dielectric walls 220, and as such may have a lower aspect ratio. In some examples, via recesses 222 have an aspect ratio of around 4:1 up to around 8:1. According to some embodiments, via recesses 222 are formed between adjacent devices that alternate with dielectric walls 220 along the second direction.

Figure 2H depicts the cross-section view of the structure shown in Figure 2G following the formation of a liner 224 within via recesses 222, according to some embodiments. Liner 224 may be conformally deposited using suitable deposition techniques, such as ALD, CVD, or PECVD. Liner 224 may be any suitable dielectric material. In some examples, liner 224 includes a low-k dielectric material such as silicon nitride, tin nitride, or tin oxide, to name a few examples. Liner 224 may be deposited to a final thickness within via recesses 222 between about 2 nm and about 5 nm.

Figure 2I depicts the cross-section view of the structure shown in Figure 2H following the formation of conductive vias 226 on liner 224 within via recesses 222, according to some embodiments. Conductive vias 226 may fill any remaining volume within via recesses 222 to form the backside vias. Conductive vias 226 may include any suitable conductive material such as tungsten, molybdenum, ruthenium, titanium, tantalum, cobalt, or any alloys thereof. As noted above, conductive vias 226 extend at least below a bottom surface of the gate structure, and may also extend below a bottom surface of dielectric fill 210. According to some embodiments, conductive vias 226 act as power or signal lines between topside interconnects and backside interconnects on the die. The completed backside vias may alternate with dielectric walls 220 between adjacent pairs of devices along the second direction.

Figure 2J depicts the cross-section view of the structure shown in Figure 2I following the removal of substrate 201 and formation of backside interconnect structures, according to some embodiments. Any topside interconnect structures (e.g., back-end-of-the-line structures) may be formed prior to the removal of substrate 201. Substrate 201 may be polished away via CMP or another grinding process to remove the substrate material. According to some embodiments, substrate 201 continues to be thinned away at least until conductive vias 226 are exposed from the backside. In some examples, portions of subfin regions 208 and/or dielectric fill 210 may also be exposed from the backside in the gate trench. According to some embodiments, subfin regions 208 may be removed from the backside and replaced with another dielectric fill 228. In some examples, dielectric fill 228 is the same material as dielectric fill 210. In some examples, dielectric fill 210 is also removed to be replaced by dielectric fill 228.

According to some embodiments, an example backside interconnect layer includes a dielectric layer 230 and one or more conductive traces 232. Dielectric layer 230 may include any suitable dielectric material, such as silicon dioxide, silicon nitride, or silicon oxynitride. Conductive traces 232 may include any suitable conductive materials, such as tungsten, ruthenium, molybdenum, or cobalt. In some examples, conductive traces 232 include the same conductive material as conductive vias 226. In some examples, conductive traces 232 contact a lower surface of conductive vias 226 to route power or signal to/from conductive vias 226. Dielectric walls 220 do not extend through any portion of dielectric layer 230, according to some embodiments.

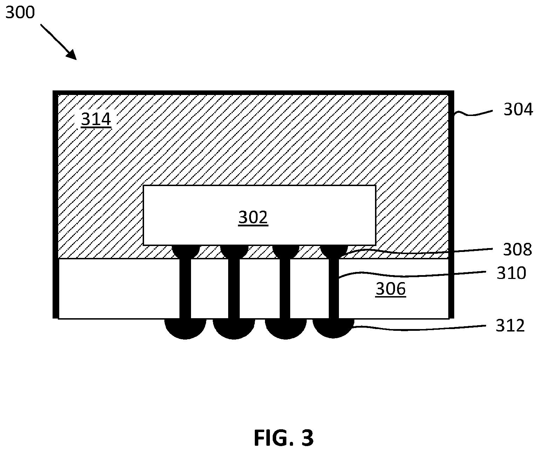

Figure 3 illustrates an example embodiment of a chip package 300, in accordance with an embodiment of the present disclosure. As can be seen, chip package 300 includes one or more dies 302. One or more dies 302 may include at least one integrated circuit having semiconductor devices, such as any of the semiconductor devices disclosed herein. One or more dies 302 may include any other circuitry used to interface with other devices formed on the dies, or other devices connected to chip package 300, in some example configurations.

As can be further seen, chip package 300 includes a housing 304 that is bonded to a package substrate 306. The housing 304 may be any standard or proprietary housing, and may provide, for example, electromagnetic shielding and environmental protection for the components of chip package 300. The one or more dies 302 may be conductively coupled to a package substrate 306 using connections 308, which may be implemented with any number of standard or proprietary connection mechanisms, such as solder bumps, ball grid array (BGA), pins, or wire bonds, to name a few examples. Package substrate 306 may be any standard or proprietary package substrate, but in some cases includes a dielectric material having conductive pathways (e.g., including conductive vias and lines) extending through the dielectric material between the faces of package substrate 306, or between different locations on each face. In some embodiments, package substrate 306 may have a thickness less than 1 millimeter (e.g., between 0.1 millimeters and 0.5 millimeters), although any number of package geometries can be used. Additional conductive contacts 312 may be disposed at an opposite face of package substrate 306 for conductively contacting, for instance, a printed circuit board (PCB). One or more vias 310 extend through a thickness of package substrate 306 to provide conductive pathways between one or more of connections 308 to one or more of contacts 312. Vias 310 are illustrated as single straight columns through package substrate 306 for ease of illustration, although other configurations can be used (e.g., damascene, dual damascene, through-silicon via, or an interconnect structure that meanders through the thickness of substrate 306 to contact one or more intermediate locations therein). In still other embodiments, vias 310 are fabricated by multiple smaller stacked vias, or are staggered at different locations across package substrate 306. In the illustrated embodiment, contacts 312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 312, to inhibit shorting.

In some embodiments, a mold material 314 may be disposed around the one or more dies 302 included within housing 304 (e.g., between dies 302 and package substrate 306 as an underfill material, as well as between dies 302 and housing 304 as an overfill material). Although the dimensions and qualities of the mold material 314 can vary from one embodiment to the next, in some embodiments, a thickness of mold material 314 is less than 1 millimeter. Example materials that may be used for mold material 314 include epoxy mold materials, as suitable. In some cases, the mold material 314 is thermally conductive, in addition to being electrically insulating.

### Methodology

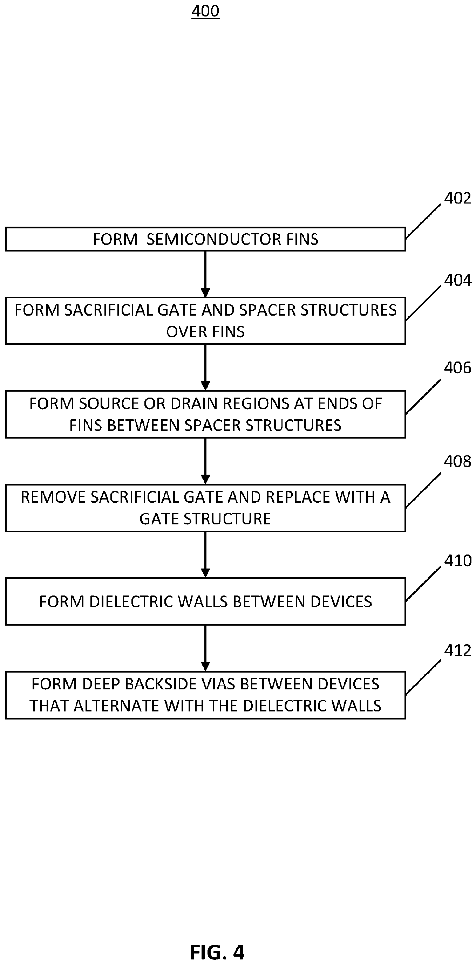

Figure 4 is a flow chart of a method 400 for forming at least a portion of an integrated circuit, according to an embodiment. Various operations of method 400 may be illustrated in Figures 2A-2J. However, the correlation of the various operations of method 400 to the specific components illustrated in the aforementioned figures is not intended to imply any structural and/or use limitations. Rather, the aforementioned figures provide one example embodiment of method 400. Other operations may be performed before, during, or after any of the operations of method 400. For example, method 400 does not explicitly describe many steps that are performed to form common transistor structures. In other examples, the operations of method 400 may be performed in a different order than the illustrated order.

Method 400 begins with operation 402 where a plurality of semiconductor fins are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins, or deposited into fin-shaped trenches.

According to some embodiments, a dielectric fill is formed adjacent to subfin portions of each of the fins. The dielectric fill may include silicon dioxide. According to some embodiments, the dielectric fill acts as an STI region between adjacent fins. According to some embodiments, each semiconductor device includes a subfin portion beneath a fin of alternating semiconductor layers and adjacent to the dielectric layer. The subfin may include the same material as a bulk region of the underlying semiconductor substrate.

Method 400 continues with operation 404 where a sacrificial gate and sidewall spacer structures are formed over the fins. The sacrificial gate may include any material that can be safely removed later in the process without etching or otherwise damaging the spacer structures and/or the fins. The sacrificial gate may include polysilicon while the spacer structures may include silicon nitride. The spacer structures are formed on sidewalls of the sacrificial gates and etched back to remove the spacer structure material from any horizontal surfaces. According to some embodiments, the fins extend lengthwise in a first direction while the sacrificial gate and spacer structures extend lengthwise in a second direction over each of the fins, the second direction being substantially orthogonal to the first direction.

Method 400 continues with operation 406 where source or drain regions are formed at the ends of semiconductor channel layers in each of the fins. Exposed portions of the fins not covered by the sacrificial gate and sidewall spacer structures may first be removed using, for example, an RIE process. Removing the fin portions exposes ends of one or more semiconductor channel layers extending in the first direction through the sacrificial gate and sidewall spacer structures. The source or drain regions may be epitaxially grown from the exposed ends of the semiconductor layers. In the example of a PMOS device, the corresponding source or drain region may be a semiconductor material (e.g., group IV or group III-V semiconductor materials) having a higher dopant concentration of p-type dopants compared to n-type dopants. In the example of an NMOS device, the corresponding source or drain region may be a semiconductor material (e.g., group IV or group III-V semiconductor materials) having a higher dopant concentration of n-type dopants compared to p-type dopants.

Method 400 continues with operation 408 where sacrificial materials are removed and the gate structure is formed. The sacrificial gate may be removed using an isotropic etching process that selectively removes all of the material from the sacrificial gate, thus exposing the first and second fins between the spacer structures. In the example case where GAA transistors are used, any sacrificial layers within the exposed fins between the spacer structures are also removed to leave behind nanoribbons, nanosheets, or nanowires of semiconductor material.

The gate structure may include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any conductive material, such as a metal, metal alloy, or polysilicon. The gate electrode may be deposited using electroplating, electroless plating, CVD, ALD, PECVD, or PVD, to name a few examples.

Method 400 continues with operation 410 where dielectric walls are formed between adjacent pairs of devices. Deep recesses are first formed through at least a full thickness of the gate structure and extending in the first direction into the source/drain trenches and through other gate trenches. The deep recesses may be formed using a metal gate etch process that iteratively etches through portions of the gate electrode while simultaneously protecting the sidewalls of the recess from lateral etching to provide a high height-to-width aspect ratio (e.g., aspect ratio of 5:1 or higher, or 10:1 or higher). According to some embodiments, the deep recesses also cut through at least a portion of the dielectric fill adjacent to the subfin portions.

The deep recesses are filled with one or more dielectric materials to form the dielectric walls. For example, the dielectric material may include only silicon dioxide or silicon nitride. In some examples, the dielectric material includes a first dielectric layer and a second dielectric layer on the first dielectric layer within a remaining volume of the deep recesses. The first dielectric layer may include a high-k dielectric material (e.g. materials with a dielectric constant higher than that of silicon oxide or higher than 3.9) while the second dielectric layer may include a low-k dielectric material (e.g. materials with a dielectric constant equal to or lower than that of silicon oxide or equal to or lower than 3.9). The dielectric walls may be formed between every other pair of adjacent devices along a given gate trench.

Method 400 continues with operation 412 where deep backside vias are formed between adjacent semiconductor devices. According to some embodiments, the deep backside vias are arranged between device pairs that alternate with dielectric walls between device pairs, such that each device has at least one dielectric wall adjacent to one side and at least one deep backside via adjacent to an opposite side along the second direction. The deep backside vias may be similar to the dielectric walls in that they extend through at least an entire thickness of the gate structure extend in the first direction into the source/drain trenches and through other gate trenches.

According to some embodiments, the deep backside vias include a conductive via and a liner to isolate the conductive via from the directly adjacent gate electrode. The conductive via may include any suitable conductive material such as tungsten, molybdenum, ruthenium, titanium, tantalum, cobalt, or any alloys thereof. The liner may be any suitable dielectric material. In some examples, the liner includes a low-k dielectric material such as silicon nitride, tin nitride, or tin oxide, to name a few examples. At least the conductive via may extend lower than a bottom surface of the dielectric fill so as to connect with later-formed backside contacts.

### Example System

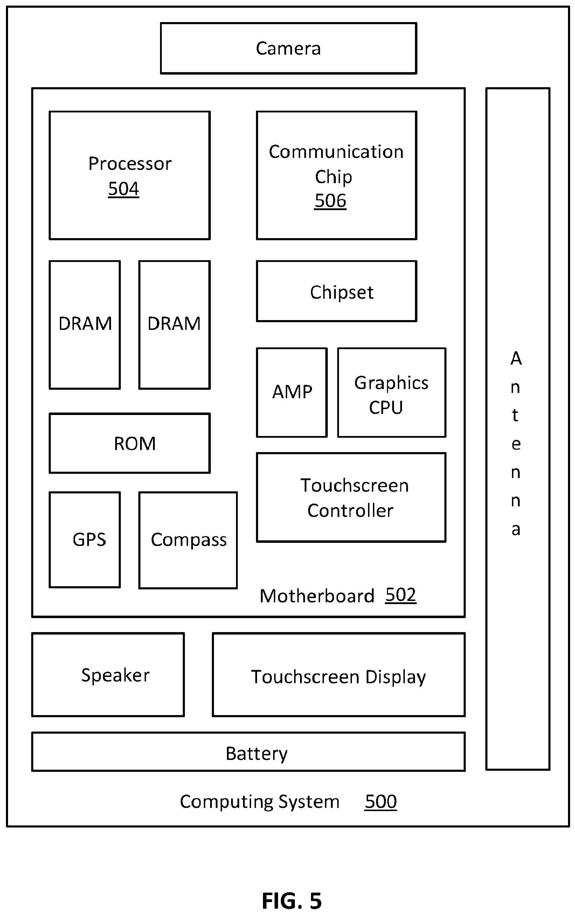

FIG. 5 is an example computing system implemented with one or more of the integrated circuit structures as disclosed herein, in accordance with some embodiments of the present disclosure. As can be seen, the computing system 500 houses a motherboard 502. The motherboard 502 may include a number of components, including, but not limited to, a processor 504 and at least one communication chip 506, each of which can be physically and electrically coupled to the motherboard 502, or otherwise integrated therein. As will be appreciated, the motherboard 502 may be, for example, any printed circuit board (PCB), whether a main board, a daughterboard mounted on a main board, or the only board of system 500, etc.

Depending on its applications, computing system 500 may include one or more other components that may or may not be physically and electrically coupled to the motherboard 502. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 500 may include one or more integrated circuit structures or devices configured in accordance with an example embodiment (e.g., a module including an integrated circuit device on a substrate, the substrate having one or more semiconductor devices with both one or more gate cuts and one or more deep backside vias extending between devices, as variously provided herein). In some embodiments, multiple functions can be integrated into one or more chips (e.g., for instance, note that the communication chip 506 can be part of or otherwise integrated into the processor 504).

The communication chip 506 enables wireless communications for the transfer of data to and from the computing system 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 500 may include a plurality of communication chips 506. For instance, a first communication chip 506 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

The processor 504 of the computing system 500 includes an integrated circuit die packaged within the processor 504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 506 also may include an integrated circuit die packaged within the communication chip 506. In accordance with some such example embodiments, the integrated circuit die of the communication chip includes one or more semiconductor devices as variously described herein. As will be appreciated in light of this disclosure, note that multi-standard wireless capability may be integrated directly into the processor 504 (e.g., where functionality of any chips 506 is integrated into processor 504, rather than having separate communication chips). Further note that processor 504 may be a chip set having such wireless capability. In short, any number of processor 504 and/or communication chips 506 can be used. Likewise, any one chip or chip set can have multiple functions integrated therein.

In various implementations, the computing system 500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a semiconductor device having a semiconductor region extending in a first direction from a first source or drain region to a second source or drain region, and a gate electrode extending in a second direction over the semiconductor region, a dielectric wall extending in the first direction through an entire thickness of the gate electrode and extending in the first direction adjacent to the first source or drain region and the second source or drain region, and a conductive via extending in the first direction through an entire thickness of the gate electrode and extending in the first direction adjacent to the first source or drain region and the second source or drain region. The semiconductor device is between the dielectric wall and the conductive via along the second direction.

Example 2 includes the integrated circuit of Example 1, further comprising a liner between the conductive via and the gate electrode.

Example 3 includes the integrated circuit of Example 2, wherein the liner comprises a low-k dielectric material.

Example 4 includes the integrated circuit of Example 2 or 3, wherein the dielectric wall has a greatest width along the second direction between about 10 nm and about 20 nm, and the conductive via plus the liner has a greatest width along the second direction between about 20 nm and about 30 nm.

Example 5 includes the integrated circuit of any one of Examples 1-4, further comprising a dielectric fill beneath the gate electrode.

Example 6 includes the integrated circuit of Example 5, wherein the conductive via extends through an entire thickness of the dielectric fill.

Example 7 includes the integrated circuit of Example 6, wherein the conductive via contacts a conductive layer beneath the dielectric fill.

Example 8 includes the integrated circuit of any one of Examples 1-7, wherein the dielectric wall comprises silicon and nitrogen.

Example 9 includes the integrated circuit of any one of Examples 1-8, wherein the semiconductor region comprises a plurality of semiconductor nanoribbons.

Example 10 includes the integrated circuit of Example 9, wherein the plurality of semiconductor nanoribbons comprise germanium, silicon, or a combination thereof.

Example 11 includes the integrated circuit of any one of Examples 1-10, wherein the second direction is substantially perpendicular to the first direction.

Example 12 is a printed circuit board comprising the integrated circuit of any one of Examples 1-11.

Example 13 is an electronic device having a chip package comprising one or more dies. At least one of the one or more dies includes a semiconductor device having a semiconductor region extending in a first direction from a first source or drain region to a second source or drain region, and a gate electrode extending in a second direction over the semiconductor region, a dielectric wall extending in the first direction through an entire thickness of the gate electrode and extending in the first direction adjacent to the first source or drain region and the second source or drain region, and a conductive via extending in the first direction through an entire thickness of the gate electrode and extending in the first direction adjacent to the first source or drain region and the second source or drain region. The semiconductor device is between the dielectric wall and the conductive via along the second direction.

Example 14 includes the electronic device of Example 13, wherein the at least one of the one or more dies further comprises a liner between the conductive via and the gate electrode.

Example 15 includes the electronic device of Example 14, wherein the liner comprises a low-k dielectric material.

Example 16 includes the electronic device of Example 14 or 15, wherein the dielectric wall has a greatest width along the second direction between about 10 nm and about 20 nm, and the conductive via plus the liner has a greatest width along the second direction between about 20 nm and about 30 nm.

Example 17 includes the electronic device of any one of Examples 13-16, wherein the at least one of the one or more dies further comprises a dielectric fill beneath the gate electrode.

Example 18 includes the electronic device of Example 17, wherein the conductive via extends through an entire thickness of the dielectric fill.

Example 19 includes the electronic device of Example 18, wherein the conductive via contacts a conductive layer beneath the dielectric fill.

Example 20 includes the electronic device of any one of Examples 13-19, wherein the dielectric wall comprises silicon and nitrogen.

Example 21 includes the electronic device of any one of Examples 13-20, wherein the semiconductor region comprises a plurality of semiconductor nanoribbons.

Example 22 includes the electronic device of Example 21, wherein the plurality of semiconductor nanoribbons comprise germanium, silicon, or a combination thereof.

Example 23 includes the electronic device of any one of Examples 13-22, wherein the second direction is substantially perpendicular to the first direction.

Example 24 includes the electronic device of any one of Examples 13-23, further comprising a printed circuit board, wherein the chip package is coupled to the printed circuit board.

Example 25 is a method of forming an integrated circuit. The method includes forming a fin comprising semiconductor material, the fin extending above a substrate and extending in a first direction; forming a dielectric layer adjacent to a bottom portion of the fin; forming source or drain regions at opposite ends of the fin; forming a sacrificial material over the source or drain regions; forming a gate structure on the dielectric layer and over the semiconductor material and extending in a second direction; forming a dielectric wall through an entire thickness of the gate structure and through an entire thickness of the sacrificial material, the dielectric wall extending in the first direction adjacent to a first side of the fin; and forming a conductive via through an entire thickness of the gate structure and through an entire thickness of the sacrificial material, the conductive via extending in the first direction adjacent to a second side of the fin opposite from the first side of the fin.

Example 26 includes the method of Example 25, wherein the semiconductor material includes an alternating stack of first semiconductor layers and second semiconductor layers, the method further comprising removing the second semiconductor layers to form suspended nanoribbons from the first semiconductor layers.

Example 27 includes the method of Example 25 or 26, further comprising forming a dielectric liner between the conductive via and the gate structure and between the conductive via and the sacrificial material.

Example 28 includes the method of any one of Examples 25-27, wherein forming the conductive via comprises forming the conductive via through an entire thickness of the dielectric layer.

Example 29 includes the method of Example 28, further comprising forming a conductive layer beneath the dielectric layer such that the conductive layer contacts the conductive via.

Example 30 is an integrated circuit that includes a first semiconductor device having a first semiconductor region extending in a first direction from a first source or drain region to a second source or drain region, and a first gate structure extending in a second direction over the first semiconductor region, and a second semiconductor device having a second semiconductor region extending in the first direction from a third source or drain region to a fourth source or drain region, and a second gate structure extending in the second direction over the second semiconductor region. The third source or drain region is aligned with the first source or drain region along the second direction, and the fourth source or drain region is aligned with the second source or drain region along the second direction. The integrated circuit further includes a dielectric wall extending in the first direction between and contacting the first gate structure and the second gate structure, extending in the first direction between the first and third source or drain regions, and extending in the first direction between the second and fourth source or drain regions. The integrated circuit further includes a first conductive via extending in the first direction through an entire thickness of the first gate structure and extending in the first direction adjacent to the first source or drain region and the second source or drain region, such that the first semiconductor device is between the dielectric wall and the first conductive via along the second direction, and a second conductive via extending in the first direction through an entire thickness of the second gate structure and extending in the first direction adjacent to the third source or drain region and the fourth source or drain region, such that the second semiconductor device is between the dielectric wall and the second conductive via along the second direction.

Example 31 includes the integrated circuit of Example 30, further comprising a first liner between the first conductive via and the first gate structure and a second liner between the second conductive via and the second gate structure.

Example 32 includes the integrated circuit of Example 31, wherein the first liner and the second liner comprise a low-k dielectric material.

Example 33 includes the integrated circuit of any one of Examples 30-32, further comprising a dielectric fill beneath the first gate structure and the second gate structure.

Example 34 includes the integrated circuit of Example 33, wherein the first and second conductive vias extend through an entire thickness of the dielectric fill.

Example 35 includes the integrated circuit of Example 34, wherein the first conductive via and/or the second conductive via contacts a conductive layer beneath the dielectric fill.

Example 36 includes the integrated circuit of any one of Examples 30-35, wherein the dielectric wall comprises silicon and nitrogen.

Example 37 includes the integrated circuit of any one of Examples 30-36, wherein the second direction is substantially perpendicular to the first direction.

Example 38 is a printed circuit board that includes the integrated circuit of any one of Examples 30-37.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a semiconductor device having a semiconductor region extending in a first direction from a first source or drain region to a second source or drain region, and a gate electrode extending in a second direction over the semiconductor region;
a dielectric wall extending in the first direction through an entire thickness of the gate electrode and extending in the first direction adjacent to the first source or drain region and the second source or drain region; and
a conductive via extending in the first direction through an entire thickness of the gate electrode and extending in the first direction adjacent to the first source or drain region and the second source or drain region, such that the semiconductor device is between the dielectric wall and the conductive via along the second direction.

2. The integrated circuit of claim 1, further comprising a liner between the conductive via and the gate electrode.

3. The integrated circuit of claim 2, wherein the liner comprises a low-k dielectric material.

4. The integrated circuit of claim 2 or 3, wherein the dielectric wall has a greatest width along the second direction between about 10 nm and about 20 nm, and the conductive via plus the liner has a greatest width along the second direction between about 20 nm and about 30 nm.

5. The integrated circuit of any one of claims 1 through 4, further comprising a dielectric fill beneath the gate electrode.

6. The integrated circuit of claim 5, wherein the conductive via extends through an entire thickness of the dielectric fill.

7. The integrated circuit of claim 6, wherein the conductive via contacts a conductive layer beneath the dielectric fill.

8. The integrated circuit of any one of claims 1 through 7, wherein the dielectric wall comprises silicon and nitrogen.

9. The integrated circuit of any one of claims 1 through 8, wherein the semiconductor region comprises a plurality of semiconductor nanoribbons.

10. The integrated circuit of claim 9, wherein the plurality of semiconductor nanoribbons comprise germanium, silicon, or a combination thereof.

11. The integrated circuit of any one of claims 1 through 10, wherein the second direction is substantially perpendicular to the first direction.

12. A printed circuit board comprising the integrated circuit of any one of claims 1 through 11.

13. A method of forming an integrated circuit, the method comprising:
forming a fin comprising semiconductor material, the fin extending above a substrate and extending in a first direction;
forming a dielectric layer adjacent to a bottom portion of the fin;
forming source or drain regions at opposite ends of the fin;
forming a sacrificial material over the source or drain regions;
forming a gate structure on the dielectric layer and over the semiconductor material and extending in a second direction;
forming a dielectric wall through an entire thickness of the gate structure and through an entire thickness of the sacrificial material, the dielectric wall extending in the first direction adjacent to a first side of the fin; and
forming a conductive via through an entire thickness of the gate structure and through an entire thickness of the sacrificial material, the conductive via extending in the first direction adjacent to a second side of the fin opposite from the first side of the fin.

14. The method of claim 13, wherein the semiconductor material includes an alternating stack of first semiconductor layers and second semiconductor layers, the method further comprising removing the second semiconductor layers to form suspended nanoribbons from the first semiconductor layers.

15. The method of claim 13 or 14, wherein forming the conductive via comprises forming the conductive via through an entire thickness of the dielectric layer, the method further comprising:
forming a dielectric liner between the conductive via and the gate structure and between the conductive via and the sacrificial material; and
forming a conductive layer beneath the dielectric layer such that the conductive layer contacts the conductive via.
